Europäisches Patentamt

(19) European Patent Office

Office européen des brevets

(11) Numéro de publication: **0 187 581**
**A1**

(12) # DEMANDE DE BREVET EUROPEEN

(21) Numéro de dépôt: **85402436.1**

(22) Date de dépôt: **06.12.85**

(51) Int. Cl.⁴: **G 02 B 6/42**

(30) Priorité: **11.12.84 FR 8418928**

(43) Date de publication de la demande:
**16.07.86 Bulletin 86/29**

(84) Etats contractants désignés:
**DE GB IT NL SE**

(71) Demandeur: THOMSON-CSF
173, Boulevard Haussmann
F-75379 Paris Cedex 08(FR)

(72) Inventeur: **Meunier, Paul-Louis**
THOMSON-CSF SCPI 173, bld Haussmann
F-75379 Paris Cedex 08(FR)

(72) Inventeur: **Razeghi, Manijeh**
THOMSON-CSF SCPI 173, bld Haussmann
F-75379 Paris Cedex 08(FR)

(72) Inventeur: **Castera, Jean-Paul**
THOMSON-CSF SCPI 173, bld Haussmann
F-75379 Paris Cedex 08(FR)

(72) Inventeur: **Duchemin, Jean-Pascal**
THOMSON-CSF SCPI 173, bld Haussmann
F-75379 Paris Cedex 08(FR)

(74) Mandataire: **Lepercque, Jean et al,**
THOMSON-CSF SCPI 19, avenue de Messine
F-75008 Paris(FR)

(54) **Diodes émettrices/réceptrices de lumière, et éléments de transmission optiques non réciproques, intégrés, et leur procédé de fabrication.**

(57) Selon l'invention, le guide (6) en matériau ferrimagnétique (YIG) est déposé par épitaxie sur une zone (2) d'un grenat (1) de gadolinium et gallium. Une diode (5) est également déposée par épitaxie sur le même substrat sur une zone (3) contiguë de la zone (2) et accolée à une extrémité du guide (6). Le paramètre de maille du matériau semiconducteur de la diode (5) est égal, multiple ou sous-multiple de celui du grenat (1).

L'invention permet ainsi de réaliser sur un même substrat une diode émettrice/réceptrice de lumière et un guide de transmission optique non réciproque (ou isolateur).

FIG_ 3

# DIODES EMETTRICES/RECEPTRICES DE LUMIERE
# ET ELEMENTS DE TRANSMISSION OPTIQUES NON RECIPROQUES
# INTEGRES, ET LEUR PROCEDE DE FABRICATION.

L'invention concerne des diodes émettrices/réceptrices de lumière avec, associé à chaque diode un guide de transmission optique non réciproque, l'ensemble étant intégré sur le même substrat.

Dans l'art antérieur, l'isolateur est considéré comme un élément séparé de la diode et l'ensemble diode laser-isolateur doit être connecté. Ces deux éléments font l'objet d'études et de réalisation totalement différentes, en particulier ils sont obtenus sur deux substrats différents dans le cas d'une intégration.

Le couplage d'un laser à semiconducteur et d'une fibre optique s'accompagne toujours du retour d'une fraction de la puissance lumineuse vers le laser. Ces réflexions parasites ont plusieurs origines possibles : sauts d'indice (entrée de la fibre, connecteurs, épissures, extrémité de la fibre), courbure de la fibre, rétro-diffusion.

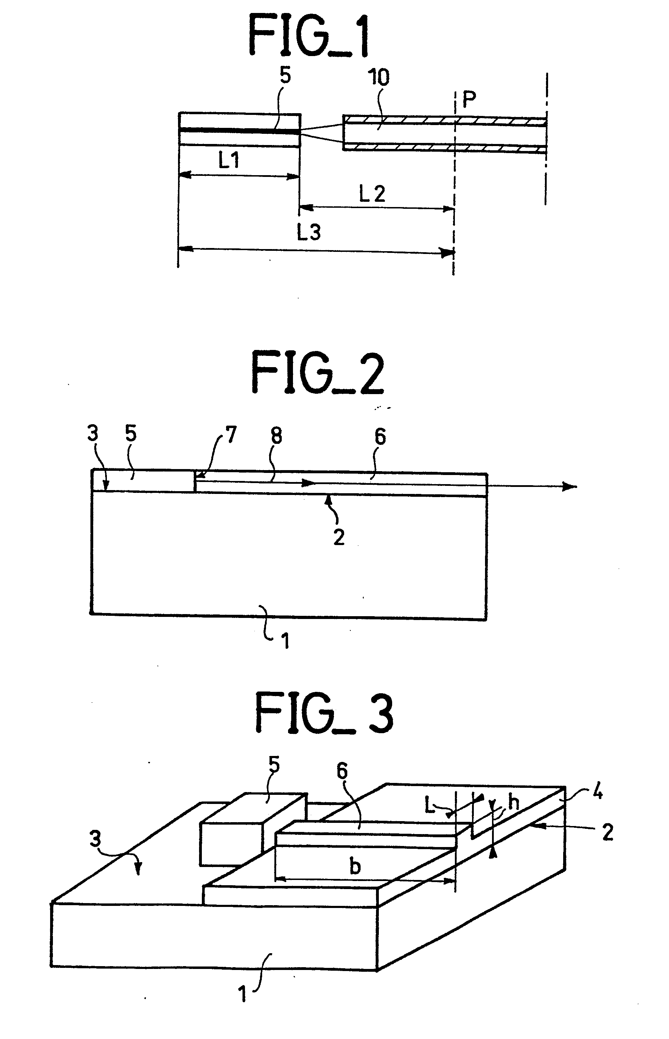

Le schéma de la figure 1 représente une source laser 5 couplée directement à une fibre optique 10. Supposons qu'une réflexion parasite ait pour origine le plan P, tel qu'indiqué sur la figure 1, ce plan peut être assimilé à un miroir dont le coefficient de réflexion dépend de la quantité de lumière réfléchie en cet endroit de la fibre. Le plan P et les deux miroirs du laser constituent deux résonateurs qui conditionnent le fonctionnement de la cavité laser.

Dans ce qui suit, on considére successivement le cas d'une réflexion à faible distance et celui d'une réflexion lointaine.

Dans le cas d'une réflexion proche, l'ensemble laser-fibre oscille préférentiellement à une longueur d'onde où le gain est maximum et où les modes du laser et des deux cavités externes coincident. Ces modes sont distants en fréquence d'une quantité $\Delta f$ qui vérifie la relation :

$$\Delta f = \frac{v}{2L} \qquad (1)$$

où $v$ est la vitesse de la lumière dans le milieu que l'on considère et L la longueur de ce milieu.

Toute variation de $L_2$ (voir Figure 1) entraîne selon la relation (1) précédente, un glissement des modes des cavités externes. Les trois résonateurs sont alors accordés à une longueur d'onde différente. On observe un saut de mode dans l'émission laser. Si le milieu qui constitue la fibre est dispersif (c'est en particulier le cas à $\lambda = 1,55 \mu m$), il résulte de ce changement de longueur d'onde une variation du retard dans la propagation. Un exemple dans le cas d'une transmission à 2,24 Gbit/s où l'on considère la réflexion à l'entrée de la fibre monomode montre qu'une variation de 2000 Å de la distance entre le laser et la fibre entraîne une variation de retard de 0,28 ns, valeur supérieure à une demi-période à la fréquence considérée.

Or, dans l'état actuel de la technologie des interfaces fibre-laser, cette valeur peut être rapidement atteinte si le dispositif subit des variations de pression, de température ou d'accélération ou s'il est soumis à des vibrations mécaniques.

Dans le cas d'une réflexion lointaine, par exemple dans le cas d'une perturbation engendrée par une réflexion de 10 % à 5 mètres de la source laser, on ne remarque aucune perturbation entre l'instant to du début de l'impulsion et l'instant to + 50 ns, car 50 ns représente le temps nécessaire au signal pour parcourir les 10 mètres d'aller-retour entre le laser et le point de réflexion. En revanche, à partir de to + 50 ns, l'impulsion est fortement perturbée. Le spectre de ce bruit est un peigne de fréquences, l'écart entre deux fréquences voisines étant égal à l'inverse du temps de parcours entre le laser et l'endroit de la réflexion. Enfin, l'effet des réflexions parasites sur le taux d'erreur montre que les perturbations sont d'autant plus importantes que le débit est élevé. Les effets de cavités sont observés quand les réflexions ont lieu à des distances inférieures ou égales à la longueur de cohérence du laser. Les réflexions parasites à des distances supérieures (quelques Km) ont pour effet de modifier le seuil du laser, sa linéarité et son bruit. Or, il n'existe pas à l'heure actuelle de moyen efficace pour empêcher tout retour de lumière (longue distance) vers la source.

Par ailleurs, l'effet d'une réflexion parasite sur la source est lié à la nature du laser. La sensibilité aux réflexions dépend en effet du degré de cohérence. Ainsi, un laser multimode à guidage par gain acceptera un taux de réflexions parasites beaucoup plus important qu'un laser à guidage par indice. Les réflexions maximales, en intensité, tolérables afin d'éviter les perturbations décrites ci-dessus, ont sensiblement pour valeur :

. laser à guidage par gain : $10^{-3}$

. laser à guidage par indice : $10^{-6}$

Ces valeurs sont faibles, surtout pour les lasers à guidage par indice. Or, il se trouve que c'est ce type de source qui est à l'heure actuelle étudiée et qui constituera dans l'avenir l'émetteur dans les liaisons monomodes. La nécessité d'un isolateur est alors une implication logique. Il faut enfin remarquer, en ce qui concerne les lasers à guidage par gain, que leur sensibilité aux réflexions est d'autant plus grande que leur largeur spectrale $\Delta \lambda$ est faible. La limite à partir de laquelle l'effet des réflexions est inacceptable pour ce type de source est $\Delta \lambda = 2,5 \, nm$.

On connaît les isolateurs en volume qui ont fait l'objet de nombreux travaux depuis une dizaine d'années. A titre d'exemples, l'article "Components for Optical fiber system" de la revue GEC Journal of Research, volume 2, No. 2 - 1984, pages 116 et 117 donne la description de tels isolateurs en volume.

Les hauts débits d'information exigent des sources monomodes et donc des isolateurs monomodes associés.

Par contre, les isolateurs en optique intégrée monomode sont moins connus parce que plus difficiles à réaliser. Néanmoins, la demande de brevet n° 77.28 065 déposée le 16 septembre 1977 décrit un isolateur intégré constitué d'une ou plusieurs couches d'un grenat d'Yttrium-Fer (YIG) épitaxiées sur un substrat isolant tel qu'un grenat de gadolinium et gallium (GGG) à très faible épaisseur pour assurer une monomodicité de transmission.

Les diodes lasers font actuellement l'objet d'énormes travaux dans le monde. Elles sont principalement produites à partir de composés ternaires ou quaternaires et utilisant par exemple les éléments indium, gallium, aluminium, arsenic phosphore, antimoine.

4 0187581

A titre d'exemple, l'article "CROISSANCE ET CARACTERISATION DE L'HETEROJONCTION ET DE PUITS QUANTIQUES Ga In As - InP obtenues par MOCVD" de M.RAZEGHI publié dans la revue technique THOMSON-CSF - Vol. 16 - No. 1 de mars 1984 décrit une production par hépitaxie d'hétérojonctions. Il est à noter que dans le titre cité MOCVD (Metalorganic Chemical Vapor Deposition) signifie : Epitaxie en phase vapeur d'organométalliques.

Dans l'état actuel de la technique, les diodes lasers sont fabriquées séparément des guides de transmission. Une diode laser est ensuite couplée à un guide. Cependant, malgré le soin apporté à la réalisation de ce dispositif, il existe fréquemment des réflexions au niveau du couplage. Ces réflexions reviennent sur la diode laser et perturbent son fonctionnement.

Par contre, l'intégration sur un même susbtrat d'une source laser et d'un guide de transmission optique associé pose des problèmes. En effet, il convient que le substrat soit isolant et que les matériaux épitaxiés possèdent des paramètres de mailles voisins pour obtenir des épitaxies correctes.

L'invention fournit un tel composant et son procédé de réalisation.

L'invention a donc pour objet des diodes émettrices/réceptrices de lumière et des éléments de transmission optiques non réciproques intégrés sur un même substrat, caractérisés en ce que le substrat est un grenat et comporte au moins une première et une deuxième zone contiguës, la première zone étant revêtue d'une couche d'un matériau ferrimagnétique dans laquelle sont formés des guides de transmission dont une extrémité se trouve à la limite de séparation des deux zones, la deuxième zone étant munie de diodes lasers émettrices ou réceptrices accolées chacune à une dite extrémité de chaque guide de transmission, lesdites diodes lasers étant constituées de matériaux dont le paramètre de maille est sensiblement égal, multiple ou sous-multiple de celui du grenat.

L'invention concerne également un procédé de fabrication de sources optiques et d'éléments de transmission optiques non réciproques intégrés sur le même substrat tels que décrits précédemment, caractérisé en ce qu'il comporte les phases suivantes :

a) masquage de la deuxième zone du substrat ;

b) croissance d'une couche de matériau ferrimagnétique sur la première zone du substrat ;

c) réalisation de guides de transmission optiques dans la couche de matériau ferrimagnétique, une extrémité de chaque guide aboutissant à la limite de séparation des deux zones du substrat ;

d) retrait du masquage de la phase a) ;

e) croissance dans la deuxième zone du substrat, accolées auxdites extrémités des guides de transmission, de diodes lasers dont le matériau possède un paramètre de maille sensiblement égal, multiple ou sous-multiple de celui du substrat ;

f) découpe de l'ensemble obtenu pour fournir des composants comprenant chacun au moins une source optique et un guide associé.

L'invention sera mieux comprise et d'autres caractéristiques apparaîtront à l'aide de la description qui suit faite en se référant aux figures annexées qui représentent :

- la figure 1, une disposition selon l'art connu.

- la figure 2, une vue en coupe du dispositif de l'invention.

- la figure 3, une vue en perspective du dispositif de l'invention.

- la figure 4, une vue de dessus d'un exemple de réalisation de l'invention.

- la figure 5, une vue en coupe d'un guide selon l'invention.

- la figure 6, une vue en coupe d'une variante d'un guide selon l'invention.

- la figure 7, une variante de réalisation du dispositif selon l'invention.

- la figure 8, un exemple de réalisation d'un isolateur en volume selon l'invention.

- les figures 9, 10 et 11 des variantes de réalisation du dispositif selon l'invention prévoyant des zones ayant subi des implantations ioniques.

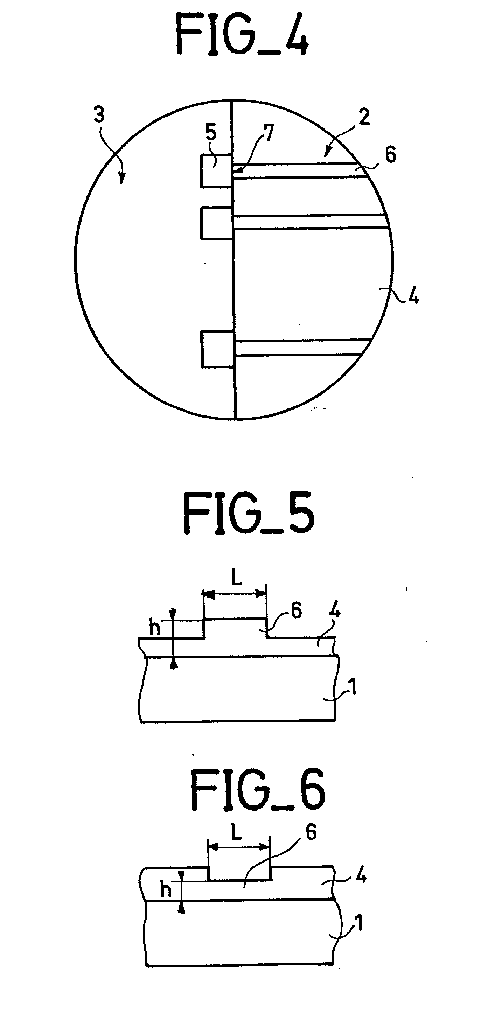

En se reportant aux figures 2 et 3, on va tout d'abord décrire une diode laser émettant un faisceau lumineux dans un guide d'onde intégré sur le même substrat que la diode laser.

Sur les figures 2 et 3, on trouve donc un substrat 1 réalisé dans un grenat de gadolinium et gallium (GGG). Ce substrat 1 comporte à sa surface supérieure deux zones 2 et 3 contiguës. La zone 2 supporte une couche d'un matériau ferrimagnétique 4 dans laquelle est pratiqué un guide de transmis-

0187581

sion 6. Le matériau ferrimagnétique est, par exemple, un grenat d'Yttrium et de Fer. Selon le domaine d'application de l'invention, les dimensions du guide auront des valeurs particulières. Par exemple, pour que le guide soit monomode, ses dimensions seront de l'ordre de quelques microns pour la largeur L ainsi que pour la hauteur h et cela selon la nature et notamment l'indice de réfraction des matériaux encadrant le guide. Sa longueur b sera par exemple de quelques millimètres.

La zone 3 comporte une diode laser 5 implantée sur le substrat à proximité d'une extrémité du guide 6, c'est-à-dire à moins d'un micron de cette extrémité, voire chevauchant cette extrémité.

La nature du matériau constituant la diode laser est telle que son paramètre de maille est égal ou est un multiple ou un sous-multiple du paramètre de maille du substrat. On considère par ailleurs, que la croissance peut avoir lieu suivant une direction cristallographique différente de celle du substrat.

Le substrat peut être un grenat de gadolinium et gallium, dont le paramètre de maille est de 12,383 Angströms et la diode laser peut être constituée par des éléments des classes III et V ou (II VI)de la classification périodiques des éléments. Par ailleurs, dans les classes III-V, on choisira des éléments permettant d'obtenir des émissions lasers de longueur d'onde d'environ 1,3 microns à 1,5 microns. Ce type d'émission est caractérisé par un minimum de dispersion dans les transmissions par fibres. C'est ainsi que, de préférence, on choisira une composition de In Ga Al Sb dont le paramètre de maille est de 6,19 Angströms. Une autre composition peut être envisagée notamment dans le cas d'un guide associé en YIG (grenat d'yttrium et de fer) dont la fenêtre de transparence s'étend de 1,1 µm à 4,5 µm.

Dans le cas d'un guide transparent aux infra-rouges, il conviendra de choisir une composition du type In As Sb.

Sur les figures 2 et 3, le guide 6 est constitué par un profilé mésa comme représenté en figure 5. Il peut être également obtenu par réalisation d'un canal dans la couche de matériau ferrimagnétique et constitution d'un guide 6 sous le canal tel que cela est représenté en figure 6.

La figure 4 représente un substrat comportant deux zones 2 et 3. Dans la zone 2, revêtue d'une couche de matériau ferrimagnétique, sont pratiqués des guides 6. A une extrémité de chaque guide, dans la zone 3 sont prévues des diodes lasers 5. L'ensemble ainsi décrit peut être utilisé tel quel ou découpé en composants indépendants comportant chacun un ou plusieurs guides et leur diode associée.

Cependant, il est possible de prévoir des diodes à chaque extrémité de chaque guide de transmission au lieu d'une extrémité seulement ce qui rentabilisera la fabrication des composants.

On va maintenant décrire un exemple d'un procédé de fabrication d'un dispositif tel que décrit précédemment.

On dispose d'une plaquette (1) d'un grenat de gadolinium et gallium. Sur une face principale de cette plaquette, on prévoit plusieurs zones, par exemple deux zones 2 et 3.

On masque par des moyens connus la zone 3 et on fait croître par épitaxie en phase liquide une couche d'un matériau ferrimagnétique telle qu'une couche d'Yttrium-Fer (YIG). Cette épitaxie est réalisée à une température d'environ 980 degrés Celsius.

L'épaisseur de la couche réalisée dépend du domaine d'application de l'invention. Par exemple, pour des guides monomodes, la couche de YIG réalisée doit être mince, quelques microns par exemple, pour assurer la monomodicité des guides de transmission qui doivent être réalisés dans cette couche. Une épitaxie comportant plusieurs couches peut aussi être envisagée.

Pour des isolateurs en volume, l'épaisseur de la couche sera supérieure à vingt fois la longueur d'onde émise par la source.

La croissance de la couche ferrimagnétique peut également se faire par pulvérisation cathodique désignée aussi par "sputtering" en terminologie anglo-saxonne suivie d'un recuit.

Ensuite, des guides de transmission 6 sont usinés dans la couche de YIG. Cet usinage se fait, par exemple, par usinage chimique à l'aide d'un acide orthophosphorique concentré à température comprise entre 180 et 220° Celsius, ou par usinage ionique. Les guides réalisés ont une section telle que représentée en figures 5 ou 6. En vue de dessus, ces guides aboutissent à la limite de séparation entre les zones 2 et 3 comme cela est représenté en figure 4.

8 0187581

Au cours de la phase suivante, après avoir démasqué la zone 3 et éventuellement masqué le guide réalisé précédemment, on réalise une épitaxie en phase vapeur de diodes lasers. Cette épitaxie est réalisée à proximité des extrémités des guides à une distance de l'extrémité des guides inférieure à un micron, de telle façon que chaque diode laser émette un faisceau lumineux dans le guide auquel elle est associée. L'épitaxie peut aussi être effectuée à l'interface du guide.

Le matériau épitaxié comprend des élements des groupes III-V, tels que l'Indium et l'Arsenic ou Indium, Gallium, Aluminium et Antimoine, dont le paramètre de maille est dans un rapport, moitié du paramètre de maille du grenat de gadolinium et gallium.

Dans le cas, par exemple, d'une réalisation par épitaxie en phase vapeur d'organométalliques, désignés par MOCVD (Metalorganic Chemical Vapor Déposition) en terminologie anglo-saxonne, l'épitaxie se fait entre 450 et 700 degrés Celsius sous une pression comprise entre 50 millibars et 500 millibars. La vitesse de dépôt pour que l'adaptation entre le matériau épitaxié et le grenat de gadolinium et gallium se fasse correctement, est choisie de préférence entre 20 Angstroms et 300 Angstroms par minute.

La croissance de diodes lasers peut également se faire par épitaxie à jet moléculaire ou MBE (Molecular Beam Epitaxy) en terminologie anglo-saxonne.

Ayant obtenu un ensemble de diodes et de guides, on procède ensuite à une opération de découpes de façon à obtenir des composants individuels comportant chacun une ou plusieurs diodes lasers et leur guide de transmission associé.

Dans les composants ainsi réalisés, les guides constituent des isolateurs. Les diodes lasers sont donc raccordées aux dispositifs extérieurs (non représentés) par des isolateurs qui évitent que leur fonctionnement soit perturbé par des réflexions.

Il est bien évident que les valeurs numériques fournies dans la description qui précède ont été données à titre d'exemple et que d'autres valeurs pourraient permettre d'obtenir le même résultat. De même, on a considéré un matériau semiconducteur constitué d'éléments des groupes III-V mais on peut également envisager des éléments des groupes II-VI.

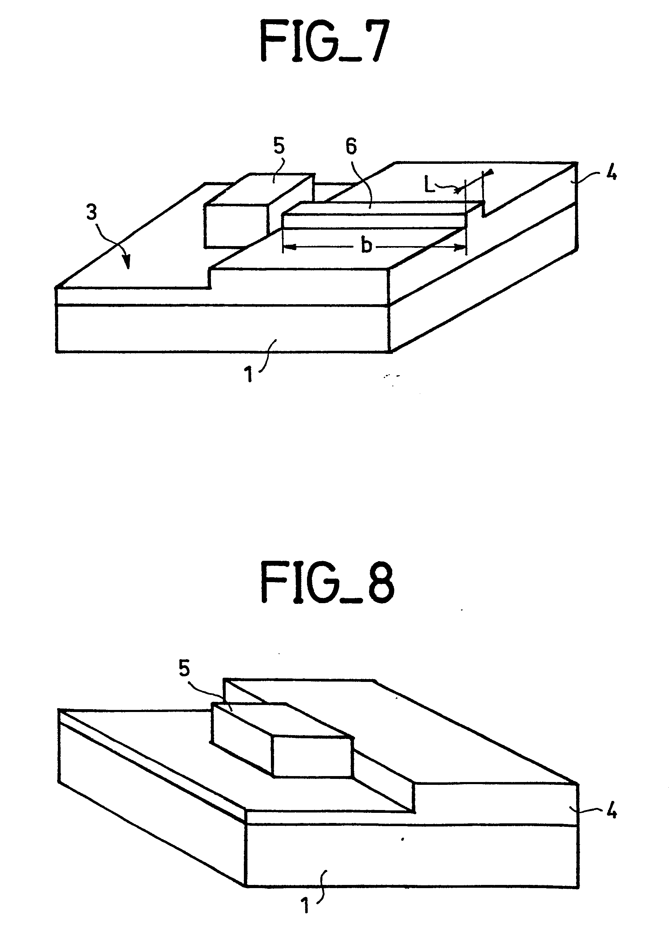

De plus, selon une variante du procédé de fabrication de l'invention, la croissance par épitaxie du matériau ferrimagnétique se fait sans masquage de la zone 3, c'est-à-dire sur toute la surface du substrat. La couche 4 de matériau ferrimagnétique est ensuite usinée pour aménager une zone 3 d'implantation des diodes lasers 5. Les diodes lasers sont ensuite épitaxiées. On obtient ainsi une diode et un guide de transmission tel que représenté en figure 7. Selon ce mode de réalisation, la zone 3 usinée laisse subsister une légère couche de matériau ferrimagnétique. La croissance de la diode 5 se fait donc sur un matériau ferrimagnétique et non sur le grenat 1 comme mentionné précédemment.

Néanmoins, les critères de choix du matériau semiconducteur constituant la diode lasers restent les mêmes notamment en ce qui concerne les paramètres de maille. En effet, les paramètres de maille du grenat (1) et du matériau ferrimagnétique sont sensiblement les mêmes.

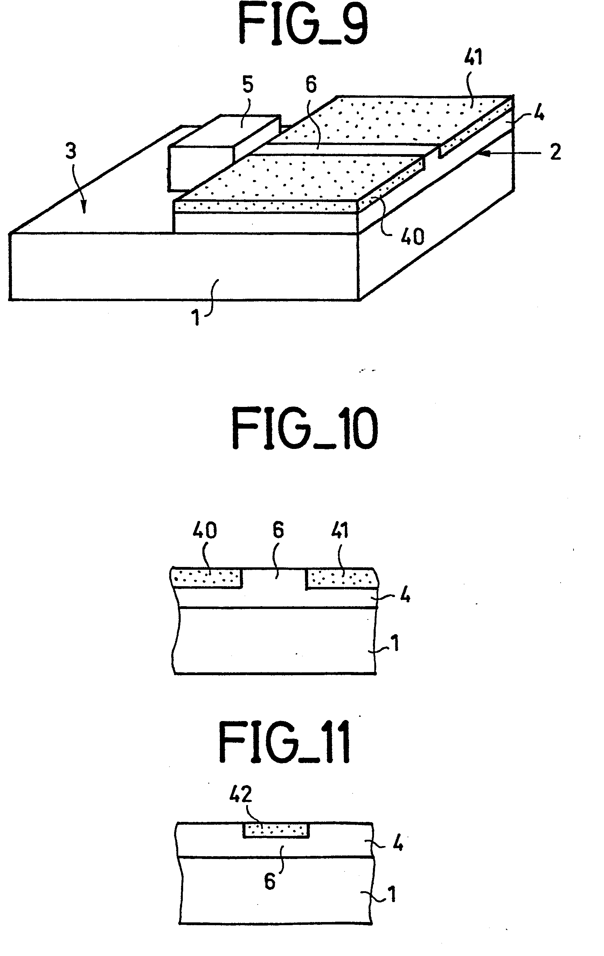

Selon une autre variante de l'invention, la phase d'usinage des guides de transmission est remplacée par une phase d'implantation ionique réalisée dans le matériau ferrimagnétique et ayant pour but de contrarier la propagation des ondes dans les régions ayant subi une implantation ionique. On obtient ainsi un composant, tel que représenté en figures 9 et 10, possédant des zones 40 et 41 ayant subi une implantation ionique et déterminant un guide mésa 6.

Pour une réalisation d'un guide vallée, on effectue une implantation ionique d'une zone 42 tel que cela est représenté en figure 11.

Enfin, comme on l'a mentionné précédemment, l'invention s'applique également à des isolateurs en volume. Dans ce cas, l'épaisseur de la couche de matériau ferrimagnétique (YIG) sera supérieure à vingt fois la longueur d'one émise par la source. De plus, comme cela est représenté par l'exemple de réalisation de la figure 8, il ne sera pas utile de prévoir, dans le procédé de fabrication, une phase d'usinage de guides de transmission, l'ensemble de la couche de matériau ferrimagnétique 4 étant utilisé comme isolateur en volume.

L'isolateur intégré en volume aura les mêmes éléments que ceux décrits dans la littérature. Néanmoins, la lumière émise par la diode laser étant déjà polarisée, on pourra s'affranchir de tout polariseur d'entrée. Un polariseur de sortie sera, par exemple, constitué d'un tronçon en fibre monocristalline.

REVENDICATIONS

1. Diodes émettrices/réceptrices de lumière et éléments de transmission optiques non réciproques intégrés sur un même substrat (1), caractérisés en ce que le substrat (1) est un grenat et comporte au moins une première et une deuxième zones (2) et (3) contiguës, la première zone (2) étant revêtue d'une couche (4) d'un matériau ferrimagnétique dans laquelle sont formés des guides de transmission (6) dont une extrémité se trouve à la limite de séparation des deux zones (2 et 3), la deuxième zone (3) étant munie de diodes à semiconducteurs (5), accolées chacune à une dite extrémité de chaque guide de transmission, lesdites diodes (5) étant constituées d'un matériau dont le paramètre de maille est sensiblement égal, multiple ou sous-multiple du paramètre de maille du grenat.

2. Dispositif selon la revendication 1, caractérisé en ce que l'épaisseur de la couche (4) de matériau ferrimagnétique est comprise entre un et dix microns selon la nature des matériaux voisins de façon à constituer un guide monomode.

3. Dispositif selon la revendication 1, caractérisé en ce que l'épaisseur de la couche (4) de matériau ferrimagnétique est supérieure à vingt fois la longueur d'onde d'émission de la diode (5) de façon à constituer un isolateur en volume.

4. Dispositif selon la revendication 1, caractérisé en ce que le grenat est un grenat de Gadolinium et Gallium.

5. Dispositif selon la revendication 1, caractérisé en ce que la couche de matériau ferrimagnétique est un grenat d'Yttrium-Fer.

6. Dispositif selon la revendication 1, caractérisé en ce que le matériau semiconducteur est constitué d'éléments des groupes III et V de la classification périodique des éléments.

7. Dispositif selon la revendication 1, caractérisé en ce que le matériau semiconducteur est constitué d'éléments des groupes II et VI de la classification périodique des éléments.

8. Dispositif selon la revendication 1, caractérisé en ce que le matériau semiconducteur comporte de l'Indium, du Gallium, de l'Aluminium et de l'Antimoine.

9. Dispositif selon la revendication 1, caractérisé en ce que les guides ont la forme de tranchées de façon à constituer des guides vallées.

10. Dispositif selon la revendication 1, caractérisé en ce que les guides ont la forme de protubérances de façon à constituer des guides mésa.

11. Dispositif selon la revendication 1, caractérisé en ce que les diodes (5) chevauchent les extrémités des guides de transmission (6).

12. Procédé de fabrication de sources optiques et d'éléments de transmission optiques non réciproques intégrés sur le même substrat selon l'une quelconque des revendications précédentes, caractérisé en ce qu'il comporte les phases suivantes :

a) masquage de la deuxième zone du substrat ;

b) croissance d'une couche de matériau ferrimagnétique sur la première zone du substrat ;

c) réalisation de guides de transmission optiques dans la couche de matériau ferrimagnétique, une extrémité de chaque guide aboutissant à la limite de séparation des deux zones du substrat ;

d) retrait du masquage de la phase a) ;

e) croissance dans la deuxième zone du substrat, accolées auxdites extrémités des guides de transmission, de diodes dont le matériau possède un paramètre de maille sensiblement égal, multiple ou sous-multiple de celui du substrat ;

f) découpe de l'ensemble obtenu pour fournir des composants comprenant chacun au moins une source optique et un guide associé.

13. Procédé de fabrication de sources optiques et d'éléments de transmission optiques non réciproques intégrés sur le même substrat selon l'une quelconque des revendications précédentes, caractérisé en ce qu'il comporte les phases suivantes :

a) croissance d'une couche de matériau ferrimagnétique sur la première zone du substrat ;

b) usinage de la couche de matériau ferrimagnétique selon la deuxième zone du substrat ;

c) réalisation de guides de transmission optiques dans la couche de matériau ferrimagnétique, une extrémité de chaque guide aboutissant à la limite de séparation de la première et de la deuxième zone du substrat ;

d) croissance dans la deuxième zone du substrat, accolées auxdites extrémités des guides de transmission, de diodes dont le matériau possède un paramètre de maille sensiblement égal, multiple ou sous-multiple de celui du substrat ;

f) découpe de l'ensemble obtenu pour fournir des composants comprenant chacun au moins une source optique et un guide associé.

14. Procédé de fabrication selon l'une des revendications 12 ou 13, caractérisé en ce que la phase de réalisation des guides de transmission consiste en un usinage réalisé par attaque chimique.

15. Procédé de fabrication selon l'une des revendications 12 ou 13, caractérisé en ce que la phase de réalisation des guides de transmission consiste en un usinage ionique.

16. Procédé de fabrication selon l'une des revendications 12 ou 13, caractérisé en ce que la phase de réalisation des guides de transmission consiste en une implantation ionique réalisée de part et d'autre des guides à réaliser de façon à modifier les conditions de propagation de la lumière dans les zones implantées.

17. Procédé de fabrication selon la revendication 13, caractérisé en ce que la phase d'usinage de la couche de matériau ferrimagnétique selon la deuxième zone du substrat consiste en un usinage réalisé par attaque chimique.

18. Procédé de fabrication selon la revendication 13, caractérisé en ce que la phase d'usinage de la couche de matériau ferrimagnétique selon la deuxième zone du substrat consiste en un usinage ionique.

19. Procédé selon l'une des revendications 12 ou 13, caractérisé en ce que la phase de croissance d'une couche de matériau ferrimagnétique sur la première partie du substrat est une épitaxie en phase liquide.

20. Procédé selon l'une des revendications 12 ou 13, caractérisé en ce que la phase de croissance d'une couche de matériau ferrimagnétique sur la première partie du substrat est une pulvérisation cathodique.

21. Procédé selon l'une des revendications 12 ou 13, caractérisé en ce que la phase de croissance de diodes sur la deuxième partie du substrat est une épitaxie en phase vapeur.

22. Procédé selon l'une des revendications 12 ou 13, caractérisé en ce que la phase de croissance de diodes sur la deuxième partie du substrat est une épitaxie à jet moléculaire.

23. Procédé selon l'une des revendications 12 ou 13, caractérisé en ce que la croissance de diodes dans la deuxième partie du substrat est faite de façon à chevaucher lesdites extrémités des guides de transmission.

# FIG_1

# FIG_2

# FIG_3

# FIG_4

# FIG_5

# FIG_6

0187581

# FIG_7

# FIG_8

# FIG_9

# FIG_10

# FIG_11

**Office européen
des brevets**

**RAPPORT DE RECHERCHE EUROPEENNE**

**0187581**

Numero de la demande

EP 85 40 2436

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| A | EP-A-0 006 042 (THOMSON-CSF) <br> * En entier * <br> --- | 1 | G 02 B 6/42 |
| A | US-A-4 186 994 (N.M. DENKIN) <br> * En entier * <br> --- | 1 | |
| A | US-A-3 968 564 (A.J. SPRINGTHORPE) <br> * En entier * <br> --- | 1 | |
| A | GB-A-2 128 768 (HITACHI) <br> * En entier * <br> --- | 1 | |
| D,A | FR-A-2 403 567 (THOMSON-CSF) <br> * En entier * | 1,4,5 | |
| | ----- | | **DOMAINES TECHNIQUES RECHERCHES (Int. Cl.4)** <br><br> G 02 B 6/42 <br> H 01 L 33/00B |

Le présent rapport de recherche a été établi pour toutes les revendications

| Lieu de la recherche | Date d'achèvement de la recherche | Examinateur |
|---|---|---|
| LA HAYE | 12-03-1986 | CALLEWAERT-HAEZEBROU |